# FASCICULE DE BREVET EUROPEEN

(11) **EP 2 688 765 B1**
(45) Date de publication et mention de la délivrance du brevet: **07.01.2015**
(21) Numéro de dépôt: 12706842.7
(22) Date de dépôt: 01.03.2012
(51) Int. Cl.: B60K 37/06, H01H 13/70, H01H 13/06

(54) **PANNEAU DE COMMANDE**
BEDIENFELD
CONTROL PANEL

(30) Priorité: 21.03.2011 FR 1152285
(43) Date de publication de la demande: 29.01.2014
(73) Titulaire: Delphi Technologies, Inc., Troy, MI 48007 (US)
(72) Inventeur: LA PAGLIA, Anthony, F-67400 Illkirch (FR); PRIGENT, Frédéric, F-67400 Illkirch (FR)
(74) Mandataire: Allain, Michel Jean Camille
(86) Numéro de dépôt international: PCT/EP2012/053526
(87) Numéro de publication internationale: WO 2012/126706

(56) Documents cités:
- GB-A- 2 327 908

## Description

### DOMAINE TECHNIQUE

L'invention est relative à l'étanchéité d'un panneau de commande tels qu'utilisé dans des automobiles et regroupant des boutons poussoirs et des molettes pour le contrôle notamment d'un système audio ou d'un système d'air conditionné.

### ARRIERE-PLAN TECHNOLOGIQUE DE L'INVENTION

Tous les véhicules et de nombreux autres systèmes sont aujourd'hui équipés de panneaux de commande où sont regroupés les interfaces nécessaires pour que l'utilisateur puisse commander des fonctions aussi variées que le système audio, l'air conditionné, le téléphone ou encore la navigation.

Dans les automobiles, ces panneaux de commande sont installés dans la console centrale dans un plan quasi vertical et sont ainsi accessibles et manipulables tant par le conducteur que par le passager avant. Les commandes sont variées et adaptées à la fonction pilotée. On trouve notamment des boutons poussoirs, des molettes rotatives et des écrans tactiles. D'un point de vue structurel, les panneaux de commande sont un empilement de couches distinctes formant un module. Ils sont généralement construits à partir d'une embase solidaire d'un circuit imprimé recouvert d'une nappe en élastomère contre laquelle est placée une façade de style pourvue des diverses interfaces. Le circuit imprimé comprend des interrupteurs électriques commutés par l'actionnement des boutons poussoir. A l'instar des claviers d'ordinateurs, la nappe en élastomère, souvent en silicone, protège le circuit imprimé contre les poussières et autres éléments extérieurs. Elle est de plus pourvue de dômes déformables placés à l'endroit des boutons poussoirs de sorte qu'un dôme exerce sur un bouton une force de rappel légère et opposée à l'enfoncement, la force faisant revenir le bouton en sa position initiale après avoir été enfoncé. De plus la nappe est échancrée ou bien pourvue d'ouvertures et autres découpes permettant le passage de diodes électroluminescentes ainsi que des éléments mécaniques d'une molette ou d'un bouton depuis la façade de style jusqu'au circuit imprimé. Pour des questions de modularité liées au choix des options du véhicule, la nappe en élastomère peut être réalisée en plusieurs nappes partielles juxtaposées sur le circuit imprimé.

L'eau est un des éléments extérieurs parmi les plus indésirables. Que ce soit pour cause de pluie sur un cabriolet, de rosée matinale, de lavage énergique de l'intérieur de la voiture ou encore pour cause de boisson renversée par accident il est impératif que chaque panneau de commande soit équipé de protections assurant que le circuit imprimé est à l'abri et ne risque pas d'être atteint par un liquide. La nappe en élastomère assure cette fonction d'étanchéité notamment par l'intermédiaire d'une barrière périphérique légèrement comprimée contre la face interne de la façade de style. Cependant le vieillissement et la dilatation différentielle des matériaux, la pluralité des nappes, les formes variées ou encore les multiples découpes rendent cette fonction d'étanchéité impossible à réaliser de manière absolue. Compte tenu de toutes ces contraintes il est important de proposer un système efficace de protection contre les liquides qui puisse s'adapter à toutes les configurations de façade de style.

Un panneau de commande comprenant toutes les caractéristiques du préambule de la revendication 1 est connu du document GB 2 327 908 A.

### RESUME DE L'INVENTION

La présente invention résout le problème ci-dessus mentionné en proposant l'agencement selon la revendication 1 d'une nappe qui ne cherche pas forcément à interdire l'entrée de l'eau dans le panneau de commande mais qui assure l'évacuation du liquide selon des chemins sûrs protégeant ainsi des zones critiques.

L'invention propose un panneau de commande, notamment pour automobile, et prévu pour être placé substantiellement dans un plan vertical, le panneau comprenant l'assemblage en couche d'une embase plane, d'une nappe en élastomère et d'une façade de style. L'embase plane comprend en outre des détecteurs pouvant être, par exemple, des contacts et interrupteurs électriques ou encore des fourches optiques. L'embase peut notamment être un circuit imprimé. La nappe en élastomère, pouvant être en silicone, est montée contre l'embase. La nappe est pourvue d'ouvertures. La façade de style a sa face interne en vis-à-vis de la surface principale de la nappe. La façade de style est pourvue en outre de boutons de commandes tels des boutons poussoirs ou des molettes rotatives.

L'embase, la nappe et la façade sont agencées de sorte que l'actionnement d'un bouton de commande entraîne sa détection par un détecteur. Notamment la commutation d'un interrupteur électrique.

Le panneau de commande est pourvu d'un moyen de protection contre les liquides. Ce moyen est venu de matière avec la nappe en élastomère et comprend des éléments saillants de la surface principale de la nappe. Lesdits éléments sont agencés de sorte que lorsque le panneau de commande est dans le plan substantiellement vertical et qu'un liquide pénètre entre la nappe et la face interne de la façade de style, le liquide est guidé selon un cheminement déterminé et ressort du panneau en ayant évité les zones critiques menant notamment aux détecteurs.

Le moyen de protection comprend une pluralité d'éléments linéaires en pente dans le plan vertical. Ainsi, dans le plan vertical, le liquide s'écoule d'un élément à l'autre depuis le haut du panneau et converge jusqu'à une sortie située en bas du panneau.

Certains éléments du moyen de protection saillent suffisamment de la surface principale de la nappe pour que leur crête soit en contact avec la surface interne de la façade de style. Ils forment ainsi des barrières étanches protégeant des zones critiques.

Certains éléments du moyen de protection saillent de la surface principale de la nappe de sorte que leur crête soit à distance de la surface interne de la façade de style. Ils forment ainsi des guides que le liquide suit par capillarité pour converger vers une sortie.

Certains éléments du moyen de protection sont formés en creux dans l'épaisseur même de la nappe. Ils forment ainsi des rigoles en pente dans le plan vertical que le liquide suit par capillarité pour converger vers une sortie.

De plus, une zone de la surface principale de la nappe peut être parfaitement lisse, de type poli miroir. Cette zone miroir favorise l'écoulement du liquide et évite sa stagnation. Ainsi, la zone miroir coopère avec les autres éléments du moyen de protection de sorte à évacuer le liquide vers une sortie.

Egalement, une zone de la surface principale de la nappe peut être grainée. Cette zone ralentit l'écoulement du liquide et évite ainsi que des gouttes n'arrivent trop promptement sur des éléments du moyen de protection et ne passent par-dessus dans un effet de cascade. La zone grainée coopère ainsi avec les autres éléments du moyen de protection de sorte à évacuer le liquide vers une sortie.

De plus, la nappe en élastomère peut comprendre une première nappe partielle pourvue d'une première partie du moyen de protection et une seconde nappe partielle pourvue d'une seconde partie du moyen de protection. Les nappes partielles sont juxtaposées. La première et la seconde partie du moyen de protection coopèrent pour évacuer vers une sortie le liquide pénétrant dans le panneau. Les nappes partielles juxtaposées se joignent selon une frontière formant une rigole en léger creux par rapport aux surfaces principales des nappes partielles. La rigole est en pente dans le plan vertical et coopère avec les éléments du moyen de protection de sorte à évacuer le liquide vers une sortie.

Le moyen de protection peut comprendre en outre des éléments linéaires saillants de la face interne de la façade de style. Ces éléments de la face interne coopèrent avec les éléments de la nappe de sorte à évacuer le liquide vers une sortie.

La nappe en élastomère peut en outre être pourvue de dômes déformables saillants de sa surface principale et agencés de sorte que l'actionnement d'un bouton de commande entraine la déformation élastique d'un dôme générant ainsi une force de rappel opposée à l'actionnement du bouton de commande. Après avoir été relâché, le bouton retrouve sa position initiale.

### DESCRIPTION DES FIGURES

Un mode de réalisation de l'invention est maintenant décrit par l'intermédiaire des figures suivantes.
La Figure 1 est une vue d'ensemble de l'intérieur d'un cabriolet où un panneau de commande selon l'invention est intégré dans la partie verticale à la console centrale.
La Figure 2 est une vue de face du panneau de commande de la Figure 1 sur lequel tombe un liquide.
La Figure 3 est une vue éclatée de l'assemblage d'un circuit imprimé, d'une nappe en élastomère et d'une façade de style composants principaux du panneau de commande des Figures 1 et 2.
La Figure 4 est une vue de face de la surface principale de la nappe en élastomère du panneau de commande des Figures 1 à 3.
La Figure 5 est une vue catalogue indiquant différents éléments pouvant être utilisés sur une nappe pour assurer l'étanchéité d'un panneau de commande. Ces différents éléments sont grossis individuellement dans les Figures 5A, 5B, 5C, 5D, 5E, 5F et 5G.
La Figure 6 est une vue de la nappe de la Figure 4 sur laquelle est indiqué par des flèches le parcours de l'écoulement d'un liquide.
La Figure 7 est une vue en plan d'une seconde nappe en élastomère réalisé selon l'invention.

### DESCRIPTION DES MODES DE REALISATION PRÉFÉRÉS

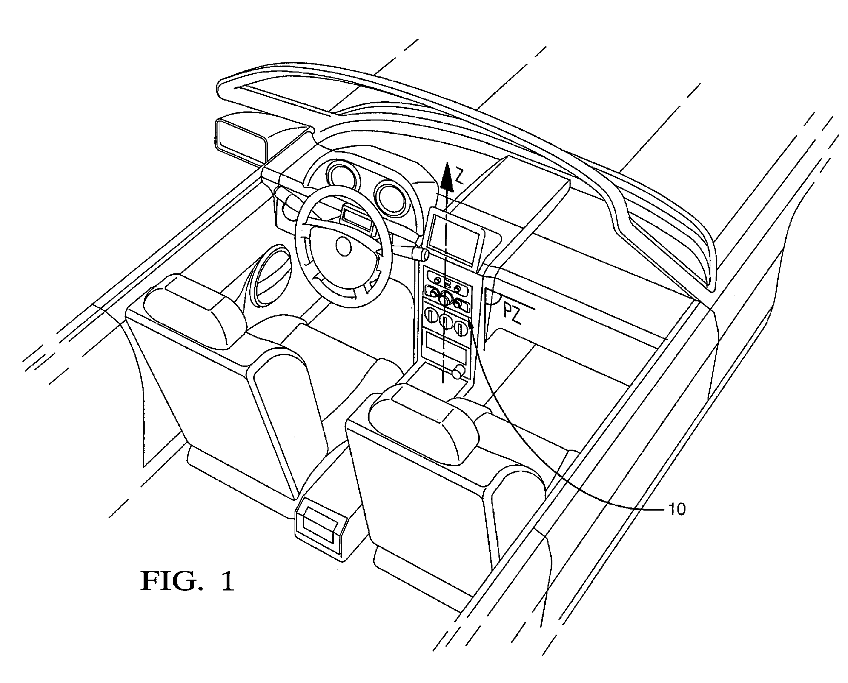

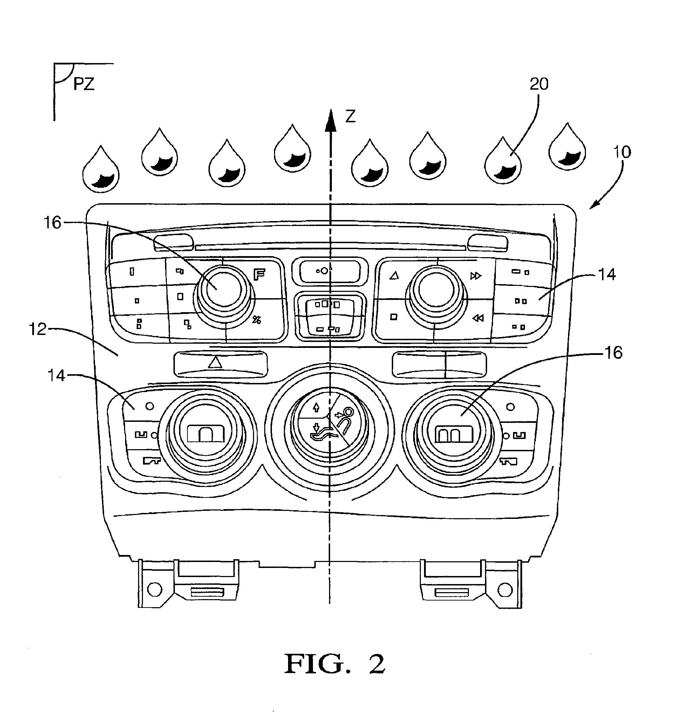

La Figure 1 présente un panneau de commande 10, objet de la présente invention, dans un environnement automobile. D'autres environnements, tels le train, l'avion, la moto ou encore n'importe quel appareil domotique possédant un panneau de commande peuvent également bénéficier des avantages de la présente invention. Sur les Figures 1 et 2 le panneau de commande est représenté installé entre les places avant d'un cabriolet, dans un plan vertical PZ de la console centrale, plan contenant l'axe vertical Z. La façade de style 12, partie visible et accessible du panneau de commande 10, regroupe les interfaces de contrôle notamment de l'air conditionné, du système audio, ou encore de la navigation. Ces fonctions sont principalement commandées au moyen de boutons poussoirs 14 et de molettes rotatives 16. D'autres moyens de commande, tels des écrans tactiles ou des interrupteurs à basculeurs sont évidemment possibles. L'orientation verticale naturelle de bas en haut, selon l'axe Z indiqué sur les figures servira à cette description.

La Figure 2 présente un exemple de façade de style 12 pourvue de boutons poussoirs 14 et de trois molettes rotatives 16. Comme schématisé par les gouttes d'eau 20 au dessus du panneau de commande 10, le panneau peut être sujet aux intempéries, voire à n'importe quelle forme de projection liquide 20.

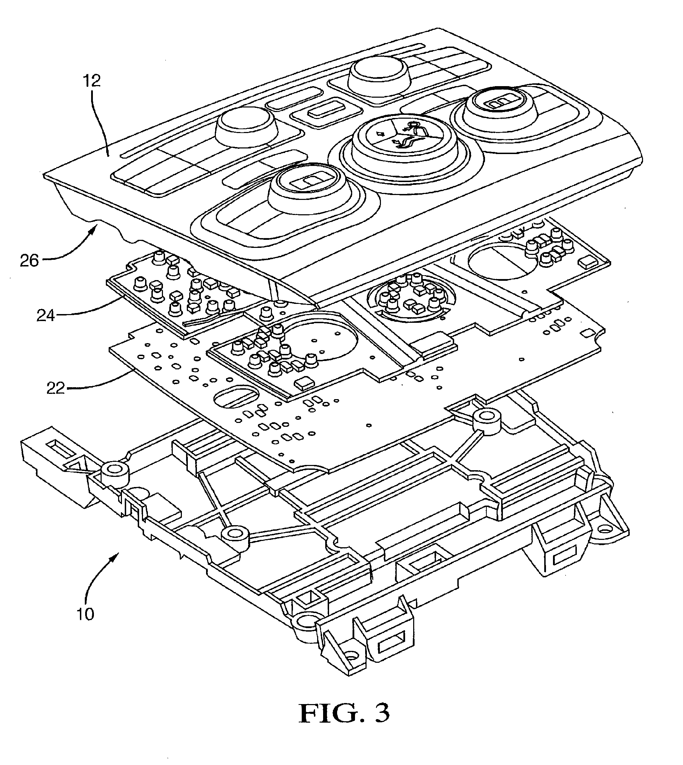

La Figure 3 présente certains composants du panneau de commande 10 dans une vue éclatée. Un circuit imprimé (PCB) 22 est recouvert d'une nappe en élastomère 24, généralement en silicone, sur laquelle est placée la façade de style 12.

Le circuit imprimé 22 est pourvu de détecteurs pouvant être des interrupteurs électriques, des fourches optiques. Il est également pourvu de composants électroniques ainsi que de l'ensemble des pistes assurant leur interconnexion électrique et de diodes électroluminescentes (LED) utilisées pour le retro-éclairage de certaines parties de la façade 12.

La façade de style 12 est la composante visible du panneau 10. Elle comporte une face interne 26 faisant face à la nappe en élastomère 24 et une face externe de laquelle émergent les boutons poussoirs 14 et les molettes rotatives 16 manipulables et dont l'actionnement fait commuter les interrupteurs du circuit imprimé 22.

La nappe en élastomère 24 placée entre le circuit imprimé 22 et la face interne 26 de la façade de style 12 recouvre le circuit imprimé 22. Elle est pourvue des ouvertures nécessaires au passage d'arbres et autres pièces mécaniques constituant notamment des molettes rotatives 16 ou d'autres détecteurs tels des fourches optiques. La nappe 24 est également pourvue des ouvertures à l'endroit des LED ou d'autres sources de lumières utilisées pour le retro-éclairage d'écrans ainsi que de dômes 30 élastiquement déformables et placés à l'endroit des interrupteurs et des boutons poussoirs 14. Sous chaque dôme, une pastille en matériau électriquement conducteur assure lors de l'enfoncement d'un dôme la commutation de l'interrupteur. Grâce à l'élasticité des dômes un bouton 14 reprend seul et automatiquement sa place d'origine, après avoir été poussé.

Lorsque le panneau 10 est assemblé, la face interne 26 de la façade de style 12 se trouve à une distance interface de la face principale 32 de la nappe 24.

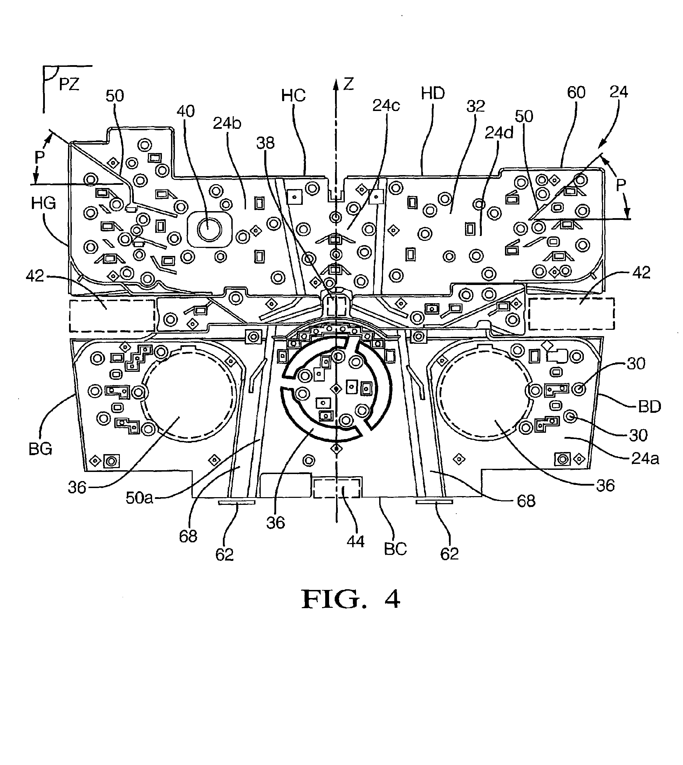

La Figure 4 détaille la nappe 24 en élastomère réalisée selon l'invention. La nappe 24 est présentée selon sa face principale 32 qui est en vis-à-vis de la face interne 26 de la façade de style 12. La nappe 24 est à peu près rectangulaire. On distingue dans la moitié basse de la nappe 24 trois ouvertures circulaires 36 horizontalement alignées. Elles correspondent aux passages de trois molettes rotatives 16 pouvant notamment permettre le réglage de l'air conditionné : direction, force et température du flux d'air. De plus une ouverture carrée 38 et une autre circulaire 40 de plus petites tailles que les trois précédentes sont respectivement réalisées au centre et en haut-à-gauche de la nappe 24. Enfin, aucun des quatre bords supérieur, inférieur, droit et gauche n'est parfaitement rectiligne et chacun présente des découpes et des encoches. Notamment, deux découpes latérales 42 rectangulaires sont symétriquement opérées dans le bord droit et dans le bord gauche et, une découpe basse 44 également rectangulaire est réalisée au centre du bord inférieur.

Dans l'exemple de nappe 24 de la Figure 4, les ouvertures circulaires 36, les découpes latérales 42, la découpe basse 44 et la petite découpe centrale 38 sont des zones critiques qui doivent impérativement être protégées contre l'entrée de liquide 20. Sur la Figure 4, ces zones sont entourées par un trait pointillé périphérique. La nappe 24 est d'épaisseur sensiblement constante et, les dômes 30 s'étendent depuis la surface principale 32 en direction de la façade de style 12.

La nappe 24 représentée sur les figures et ci-dessus brièvement décrite n'est qu'un exemple non limitatif du support de l'invention. Des nappes 24 peuvent être de toutes formes, elles peuvent être plus grandes ou plus petites, elles peuvent être pourvues d'un nombre différent d'ouvertures et d'échancrures de toutes formes. Elles peuvent être symétriques tel l'exemple des figures ou non symétriques.

La nappe 24 est pourvue d'un moyen de protection 50 contre les liquides 20. Le moyen 50 comprend des barrières 52, des nervures 54 et des rigoles 56 qui coopèrent ensemble, à l'instar d'un entonnoir, pour conduire la moindre gouttelette depuis son entrée en un point quelconque du bord supérieur 60 jusque vers une sortie basse 62. Le liquide 20 est dévié au fur et à mesure de sa descente de sorte à éviter les zones critiques 36, 38, 42, 44.

Les barrières 52 et les nervures 54 sont des éléments linéaires saillants par rapport à la surface principale 32 de la nappe 24 alors que les rigoles 56 sont des éléments linéaires en creux par rapport à la surface principale 32 de la nappe 24. Observés individuellement dans le plan vertical PZ, tel que selon la Figure 4 et plus particulièrement dans la zone grossie, ces éléments de guidage ont une pente p selon laquelle s'écoule naturellement le liquide 20.

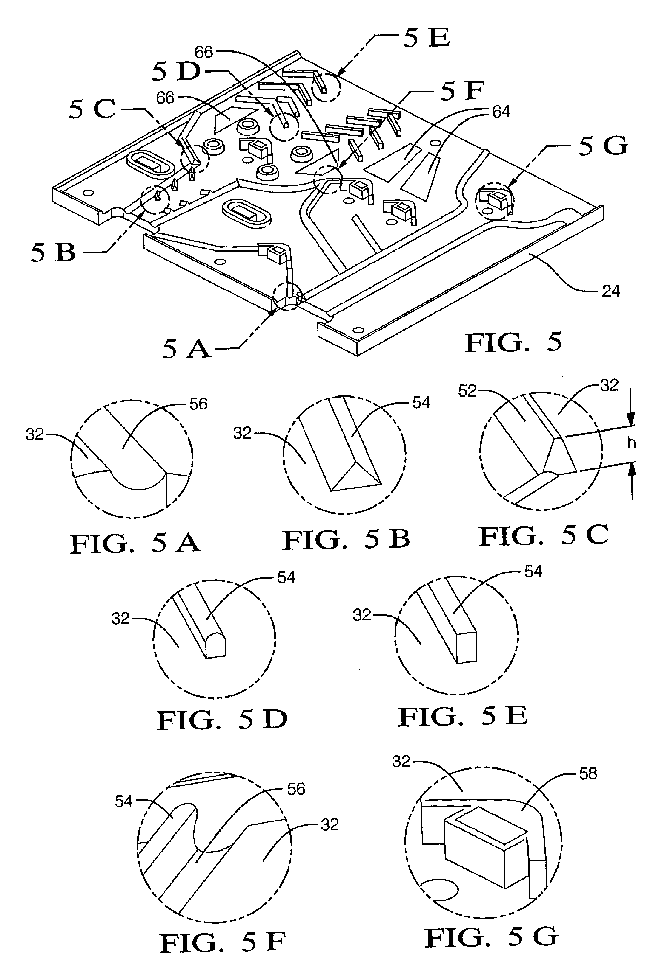

La Figure 5 et les Figures associées 5A, 5B, 5C, 5D, 5E, 5F et 5G présentent, à partir d'une deuxième nappe 24, un catalogue non limitatif de différents éléments du moyen de protection 50 contre les liquides 20. Le liquide 20 peut être guidé au moyen des barrières 52 (Fig. 5C) dites de compression. Ces barrières 52 s'élèvent par rapport à la surface principale 32 de la nappe 24 d'une hauteur h supérieure à la distance interface et ont ainsi leur crête en contact et légèrement comprimée contre la face interne 26 de la façade de style 12 lorsque le panneau 10 est assemblé. Les nervures 54 (Fig. 5B, 5D, 5E) sont moins hautes que les barrières 52 et ne contactent pas la face interne 26 de la façade de style 12. Elles peuvent notamment être de section triangulaire (Fig. 5B), rectangulaire (Fig. 5E) ou encore arrondie (Fig. 5D) selon le besoin et la configuration du panneau 10. La Figure 5 présente également les rigoles 56 (Fig. 5A) formées en creux dans l'épaisseur même de la nappe 24 et ayant des sections demi-rondes, bien que d'autres sections, carrées ou encore triangulaires, soient possibles. Une nervure 56 peut de plus être associée à une rigole 54 de sorte à former une double protection (Fig. 5F). Enfin dans le but de protéger, très localement un endroit, tel un passage pour une LED, une petite nervure 58 (Fig. 5G) en forme de toit à deux pans est placée au dessus de l'endroit à protéger.

Associés aux barrières 52, aux nervures 54, 58, et aux rigoles 56, l'écoulement du liquide 20 vers une sortie 62 peut être orienté et favorisé par des états de surface particuliers dans certaines zones de la nappe 24. Ainsi, sur la Figure 5 et seulement à titre illustratif, sont représentées deux zones 64 dont les surfaces sont parfaitement lisses, de type poli miroir, et deux zones 66 dont les surfaces sont grainées. L'écoulement est facilité dans les zones miroirs 64 et ainsi la stagnation du liquide 20 est empêchée. Dans les zones grainées 66, l'écoulement est au contraire ralenti ce qui permet d'éviter que des gouttes 20 importantes n'arrivent trop rapidement sur les nervures 54, 58, ou les rigoles 56 et ne passent par-dessus ce qui entrainerait un effet de cascade incompatible avec le guidage précis de l'écoulement.

La nappe de la Figure 4 est rectangulaire et symétriquement divisée en six zones elles-mêmes quasi rectangulaires. Trois zones hautes : gauche HG, centrale HC et droite HD, sont situées justes au dessus de trois zones basses : gauche BG, centrale BC et droite BD. Les frontières entre ces zones sont réalisées par des barrières de compression 52 s'étendant en ligne droite. De plus des barrières 52 verticales s'étendant de part et d'autre de la zone basse centrale BC délimitent deux couloirs de sorties 68. Les zones hautes HG, HC, HD, présentent toutes une légère ouverture dans la barrière 52 établissant leur frontière inférieure et, à cet endroit chaque barrière 52 prend une légère pente p de sorte à créer un entonnoir se déversant dans les couloirs de sortie 68. De même, la barrière 52 située entre les zones centrales haute HC et basse BC est en forme de chevron et guide le liquide 20 de la zone haute centrale HC vers les couloirs de sortie 68. La nappe 24 étant ainsi cloisonnée, un liquide 20 entré dans une des trois zones hautes HG, HC, HD, sort naturellement par les couloirs de sortie 68. Les zones critiques 36, 38, 42, 44, ci-avant identifiées sont protégées. En plus des barrières 52, des nervures 54 et des rigoles 56 sont placées dans les trois zones hautes HG, HC, HD. Chacun de ces éléments a une pente p qui oriente le liquide 20 dès son entrée vers les couloirs de sortie 68. Grâce à ces éléments additionnels le liquide 20 ne s'accumule pas en bas des zones hautes HG, HC, HD, mais converge au plus tôt vers une sortie 62.

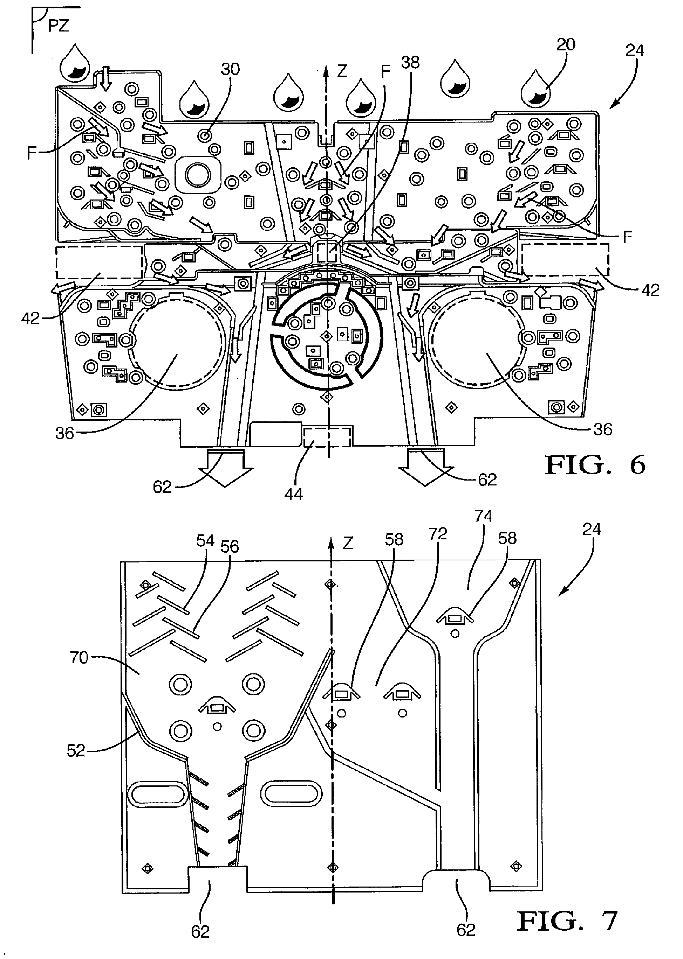

La Figure 6 indique par des flèches F divers chemins d'écoulement empruntés par un liquide 20 entré en haut du panneau 10 et conduit par les barrières 52, les nervures 54, 58, et les rigoles 56 vers les sorties 62 situées en bas.

Dans une construction alternative et, dans le but de satisfaire aux nombreuses demandes d'options différentes dont peuvent être pourvus les véhicules, la nappe 24 peut être réalisée par juxtaposition de plusieurs nappes partielles. Par exemple, des nappes partielles peuvent être préparées en fonction des différents systèmes de commande d'air conditionné et d'autres nappes partielles réalisées en fonction des différents systèmes audio. Au montage seront ensuite choisies et juxtaposées les nappes partielles correspondant au choix du client.

Ainsi, sur la Figure 4 les zones basses, BG, BC, BD, peuvent faire parti d'une première nappe partielle 24a, tandis que les trois zones hautes HG, HC, HD, peuvent constituer trois autres nappes partielles 24b, 24c, 24d, distinctes. Chaque nappe partielle 24a-24d est pourvue d'une partie 50a-50d du moyen de protection 50. Les quatre nappes partielles 24a-24d sont ensuite juxtaposées jointivement pour recouvrir le circuit imprimé 22 et ainsi les parties 50a-50d du moyen de protection 50 se complètent pour évacuer ensemble le liquide 20. La frontière entre deux nappes partielles 24a, 24b, forme une rigole 56 en pente p et est un des éléments du moyen de protection 50.

Une autre nappe 24 réalisée selon un principe similaire à la première nappe est présentée Figure 7. Les barrières 52, les nervures 54 et les rigoles 56 de cette autre nappe, également rectangulaire, forment un entonnoir gauche 70, un passage central 72 et un entonnoir droit 74. L'entonnoir gauche 70 comprend dans sa partie haute deux batteries de nervures 54, chaque batterie formant un épi. Sous les nervures 54, quatre dômes 30 sont placés en rectangle au centre duquel une zone critique rectangulaire destinée au passage d'une LED est protégé par une nervure 58 formant un toit à deux pans. La partie haute de cet entonnoir gauche 70 amène à un couloir de sortie 68 rectiligne également et pourvu de nervures 54 guidant le liquide vers le centre couloir 68.

L'entonnoir de droite 74 comprend une partie haute, de plus petite dimensions que celles de l'entonnoir de gauche 70, et un couloir de sortie 68 rectiligne et dépourvu de nervures. Au centre de sa partie haute, cet entonnoir droit 74 comprend un autre passage de LED également protégé par une nervure 58 formant un toit à deux pans.

Entre les entonnoirs gauche 70 et droit 74 se trouve un passage central 72 dans lequel deux nouveaux passages de LED sont à également protégés chacun par une nervure 58 formant un toit à deux pans. Le passage central 72 est également délimité en sa partie basse par une barrière 52 en double pente conduisant vers le canal de sortie 68 droit via une ouverture pratiquée dans une des barrières 52 délimitant ce canal de sortie 68.

Dans le mode de réalisation préféré ci-dessus décrit, la nappe 24 en élastomère est moulée et le moyen de protection 50 contre les liquides y est intégré. De manière complémentaire, des nervures peuvent être pourvues saillantes de la face interne 26 venues de matière avec la façade de style 12. Lors de l'assemblage du panneau de commande 10, des nervures 54 de la nappe 24 entrent en contact et coopèrent alors avec des nervures de la face interne 26, réalisant ainsi ensemble des barrières étanches infranchissables par un liquide 20.

## Revendications

1. Panneau de commande (10) prévu pour être placé dans un plan substantiellement vertical (PZ), notamment dans une automobile, le panneau (10) comprenant l'assemblage en couche :
- d'une embase (22) plane comprenant des détecteurs, l'embase (22) pouvant être un circuit imprimé,
- d'une nappe (24) en élastomère montée contre l'embase (22), la nappe (24) étant pourvue d'ouvertures (36, 38, 42, 44) et,
- d'une façade de style (12) dont la face interne (26) est en vis-à-vis de la surface principale (32) de la nappe (24), la façade de style (12) étant pourvue de boutons de commande (14),
l'embase (22), la nappe (24) et la façade (12) étant agencés de sorte que l'actionnement d'un bouton de commande (14) entraîne sa détection par un détecteur ;
le panneau de commande (10) est en outre pourvu d'un moyen de protection (50) contre les liquides (20) venu de matière avec la nappe en élastomère (24), le moyen de protection (50) comprenant des éléments saillants (52, 54, 58) de la surface principale (32) de la nappe (24), lesdits éléments (52, 54, 58) étant agencés de sorte que lorsque le panneau de commande (10) est dans le plan vertical (PZ) et qu'un liquide (20) pénètre entre la nappe (24) et la face interne (26) de la façade de style (12), le liquide (20) est guidé selon un cheminement déterminé et ressort du panneau (10) en ayant évité des zones critiques (36, 38, 42, 44) menant notamment aux détecteurs,
**caractérisé en ce que**
le moyen de protection (50) comprenne en outre une pluralité d'éléments linéaires en pente (p) dans le plan vertical (PZ), le liquide (20) s'écoulant dans le plan vertical (PZ) d'un élément à l'autre depuis le haut du panneau et convergeant jusqu'à une sortie (62) située en bas du panneau (10).

2. Panneau de commande (10) selon la revendication précédente dans lequel certains éléments (52) du moyen de protection (50) saillent suffisamment de la surface principale (32) de la nappe (24) pour que leur crête soit en contact avec la surface interne (26) de la façade de style (12) de sorte à former des barrières étanches protégeant des zones critiques (36, 38, 42, 44).

3. Panneau de commande (10) selon une quelconque des revendications précédentes dans lequel certains éléments (54) du moyen de protection (50) saillent de la surface principale (32) de la nappe (24) de sorte que leur crête soit à distance de la surface interne (26) de la façade de style (12) formant ainsi des guides que le liquide (20) suit par capillarité pour converger vers une sortie (62).

4. Panneau de commande (10) selon une quelconque des revendications précédentes dans lequel certains éléments (56) du moyen de protection (50) sont formés en creux dans l'épaisseur même de la nappe (24) formant des rigoles (56) en pente (p) dans le plan vertical (PZ), le liquide (20) suivant ces rigoles (56) par capillarité pour converger vers une sortie (62).

5. Panneau de commande (10) selon une quelconque des revendications précédentes dans lequel une zone (64) de la surface principale (32) de la nappe (24) est parfaitement lisse, de type poli miroir, ladite zone miroir (64) favorisant l'écoulement du liquide (20) et évitant ainsi sa stagnation et coopérant avec les autres éléments du moyen de protection (50) de sorte à évacuer le liquide (20) vers une sortie (62).

6. Panneau de commande (10) selon une quelconque des revendications précédentes dans lequel une zone (66) de la surface principale (32) de la nappe (24) est grainée ralentissant l'écoulement du liquide (20) et évitant ainsi que des gouttes n'arrivent trop promptement sur des éléments du moyen de protection (50) et ne passent par-dessus dans un effet de cascade, la zone grainée (66) coopérant ainsi avec les autres éléments du moyen de protection (50) de sorte à évacuer le liquide (20) vers une sortie (62).

7. Panneau de commande (10) selon une quelconque des revendications précédentes dans lequel la nappe (24) en élastomère comprend une première nappe partielle (24a) pourvue d'une première partie du moyen de protection (50a) et une seconde nappe partielle (24b) pourvue d'une seconde partie du moyen de protection (50b), les nappes partielles (24a, 24b) étant juxtaposées, la première et la seconde partie du moyen de protection (50a, 50b) coopérant ensemble pour évacuer vers une sortie (62) le liquide (20) pénétrant dans le panneau (10).

8. Panneau de commande (10) selon la revendication 7 dans lequel les nappes partielles (24a, 24b) juxtaposées se joignent selon une frontière formant une rigole en léger creux par rapport aux surfaces principales des nappes partielles (24a, 24b), ladite rigole étant en pente (p) dans le plan vertical (PZ) et coopérant avec les éléments du moyen de protection (50) de sorte à évacuer le liquide (20) vers une sortie (62).

9. Panneau de commande (10) selon une quelconque des revendications précédente dans lequel le moyen de protection (50) comprend en outre des éléments linéaires saillants de la face interne (26) de la façade de style (12), lesdits éléments de la face interne (26) coopérant avec des éléments de la nappe (24) de sorte à évacuer le liquide (20) vers une sortie (62).

10. Panneau de commande (10) selon une quelconque des revendications précédentes dans lequel la nappe (24) est de plus pourvue de dômes (30) déformables saillants à la surface principale (32) de la nappe (24), les dômes (30) étant agencés de sorte que l'actionnement d'un bouton de commande (14) entraîne la déformation élastique d'un dôme (30) générant une force de rappel opposée à l'actionnement du bouton de commande (14), le bouton retrouvant sa position initiale après avoir été relâché.

## Patentansprüche

1. Bedienfeld (10), das dazu vorgesehen ist, in einer im Wesentlichen senkrecht verlaufenden Ebene (PZ) angeordnet zu werden, insbesondere in einem Kraftfahrzeug, wobei das Bedienfeld (10) die schichtweise Anordnung enthält, bestehend aus
- einer ebenen Grundplatte (22) mit Sensoren, wobei die Grundplatte (22) eine gedruckte Schaltung sein kann,
- einer Auflage (24) aus Elastomer, die an die Grundplatte (22) montiert ist, wobei die Auflage (24) mit Öffnungen (36, 38, 42, 44) versehen ist,
- und aus einer Frontblende (12), deren Innenseite (26) der Hauptfläche (32) der Auflage (24) gegenüberlieget, wobei die Frontblende (12) mit Bedientasten (14) versehen ist,
wobei die Grundplatte (22), die Auflage (24) und die Frontblende (12) so angeordnet sind, dass die Betätigung einer Bedientaste (14) dessen Erfassung durch einen Sensor bewirkt;
wobei das Bedienfeld (10) ferner mit einer Schutzvorrichtung (50) zum Schutz vor Flüssigkeiten (20) versehen ist, die stoffschlüssig mit der Elastomerauflage (24) ausgebildet ist, wobei die Schutzvorrichtung (50) vorspringende Elemente (52, 54, 58) aufweist, die von der Hauptfläche (32) der Auflage (24) vorspringen, wobei die Elemente (52, 54, 58) so angeordnet sind, dass dann, wenn das Bedienfeld (10) in der senkrechten Ebene (PZ) liegt und eine Flüssigkeit (20) zwischen die Auflage (24) und die Innenseite (26) der Frontblende (12) eindringt, die Flüssigkeit (20) entlang eines bestimmten Führungswegs geführt wird und unter Umgehung kritischer Bereiche (36, 38, 42, 44), die insbesondere zu den Sensoren führen, aus dem Bedienfeld (10) austritt,
**dadurch gekennzeichnet, dass**
die Schutzvorrichtung (50) ferner eine Mehrzahl von linearen, geneigt (p) angeordneten Elementen in der senkrechten Ebene (PZ) aufweist, wobei die Flüssigkeit (20) in der senkrechten Ebene (PZ) von einem Element zum anderen vom oberen Bereich des Bedienfeldes strömt und zum im unteren Bereich des Bedienfeldes (10) liegenden Auslass (62) zusammenläuft.

2. Bedienfeld (10) nach dem vorangehenden Anspruch, wobei bestimmte Elemente (52) der Schutzvorrichtung (50) weit genug von der Hauptfläche (32) der Auflage (24) vorspringen, dass deren Grat die Innenfläche (26) der Frontblende (12) berührt, so dass dichte Sperren gebildet werden, welche die kritischen Bereiche (36, 38, 42, 44) schützen.

3. Bedienfeld (10) nach einem der vorangehenden Ansprüche, wobei bestimmte Elemente (54) der Schutzvorrichtung (50) von der Hauptfläche (32) der Auflage (24) vorspringen, so dass deren Grat von der Innenfläche (26) der Frontblende (12) beabstandet ist und dabei Führungen bilden, welchen die Flüssigkeit (20) durch Kapillarwirkung folgt, um zu einem Auslass (62) zusammenzulaufen.

4. Bedienfeld (10) nach einem der vorangehenden Ansprüche, wobei bestimmte Elemente (56) der Schutzvorrichtung (50) in der Dicke der Auflage (24) selbst hohl ausgeführt sind, wodurch geneigt (p) angeordnete Rinnen (56) in der senkrechten Ebene (PZ) gebildet werden, wobei die Flüssigkeit (20) diesen Rinnen (56) durch Kapillarwirkung folgt, um zu einem Auslass (62) zusammenzulaufen.

5. Bedienfeld (10) nach einem der vorangehenden Ansprüche, wobei ein Bereich (64) der Hauptfläche (32) der Auflage (24) vollkommen glatt und spiegelpoliert ausgeführt ist, wobei der spiegelpolierte Bereich (64) das Ablaufen der Flüssigkeit (20) begünstigt und dabei deren Stagnation vermeidet und mit den weiteren Elementen der Schutzvorrichtung (50) so zusammenwirkt, dass die Flüssigkeit (20) zu einem Auslass (62) abgeleitet wird.

6. Bedienfeld (10) nach einem der vorangehenden Ansprüche, wobei ein Bereich (66) der Hauptfläche (32) der Auflage (24) aufgeraut ist und das Ablaufen der Flüssigkeit (20) verzögert und dabei vermeidet, dass Tröpfchen nicht zu plötzlich auf Elemente der Schutzvorrichtung (50) auftreffen und nicht kaskadenartig darüber hinweg strömen, wobei der aufgeraute Bereich (66) somit mit den weiteren Elementen der Schutzvorrichtung (50) so zusammenwirkt, dass die Flüssigkeit (20) zu einem Auslass (62) abgeleitet wird.

7. Bedienfeld (10) nach einem der vorangehenden Ansprüche, wobei die Auflage (24) aus Elastomer eine erste Teilauflage (24a) aufweist, die mit einem ersten Abschnitt der Schutzvorrichtung (50a) versehen ist, sowie eine zweite Teilauflage (24b), die mit einem zweiten Abschnitt der Schutzvorrichtung (50b) versehen ist, wobei die Teilauflagen (24a, 24b) nebeneinanderliegen, wobei der erste und der zweite Abschnitt der Schutzvorrichtung (50a, 50b) zusammenwirken, um die in das Bedienfeld (10) eindringende Flüssigkeit (20) zu einem Auslass (62) abzuleiten.

8. Bedienfeld (10) nach Anspruch 7, wobei die nebeneinanderliegenden Teilauflagen (24a, 24b) entlang einer Grenze aufeinandertreffen, die eine gegenüber den Hauptflächen der Teilauflagen (24a, 24b) leicht vertieft ausgeführte Rinne bildet, wobei die Rinne in der senkrechten Ebene (PZ) geneigt (p) ausgeführt ist und mit den Elementen der Schutzvorrichtung (50) so zusammenwirkt, dass die Flüssigkeit (20) zu einem Auslass (62) abgeleitet wird.

9. Bedienfeld (10) nach einem der vorangehenden Ansprüche, wobei die Schutzvorrichtung (50) ferner lineare Elemente aufweist, die von der Innenseite (26) der Frontblende (12) vorspringen, wobei die Elemente der Innenseite (26) mit Elementen der Auflage (24) so zusammenwirken, dass die Flüssigkeit (20) zu einem Auslass (62) abgeleitet wird.

10. Bedienfeld (10) nach einem der vorangehenden Ansprüche, wobei die Auflage (24) zudem mit verformbaren Erhebungen (30) versehen ist, die an der Hauptfläche (32) der Auflage (24) vorspringen, wobei die Erhebungen (30) so angeordnet sind, dass die Betätigung einer Bedientaste (14) die elastische Verformung einer Erhebung (30) bewirkt, wodurch eine der Betätigung der Bedientaste (14) entgegengesetzte Rückstellkraft erzeugt wird, wobei die Taste in ihre ursprüngliche Position zurückkehrt, nachdem sie losgelassen wird.

## Claims

1. Control panel (10) provided to be placed in a substantially vertical plane (PZ), particularly in an automobile, the panel (10) comprising lamination of:
- a flat base (22) comprising detectors, wherein the base (22) may be a printed circuit,
- a sheet (24) of elastomer mounted against the base (22), wherein the sheet (24) is provided with openings (36, 38, 42, 44) and
- a fascia (12) of which the inner surface (26) is opposite the main surface (32) of the sheet (24), the fascia (12) being provided with control buttons (14),
- the base (22), the sheet (24) and the fascia (12) being arranged so that the actuation of a control button (14) causes detection thereof by a detector;
the control panel (10) is further provided with a means (50) of protection against liquids (20) formed integrally with the elastomer sheet (24), the means of protection (50) including elements (52, 54, 58) projecting from the main surface (32) of the sheet (24), said elements (52, 54, 58) being arranged so that, when the control panel (10) is in the vertical plane (PZ) and a liquid (20) penetrates between the sheet (24) and the inner surface (26) of the fascia (12), the liquid (20) is guided along a given path and re-emerges from the panel (10) having avoided critical areas (36, 38, 42, 44) leading in particular to the detectors,
**characterised in that** the means of protection (50) further comprises a plurality of linear elements sloping (p) in the vertical plane (PZ), the liquid (20) flowing in the vertical plane (PZ) from one element to the other from the top of the panel and converging at an outlet (62) situated at the bottom of the panel (10).

2. Control panel (10) according to the preceding claim in which some elements (52) of the means of protection (50) project sufficiently from the main surface (32) of the sheet (24) for their top surface to be in contact with the inner surface (26) of the fascia (12) so as to form watertight barriers which protect critical areas (36, 38, 42, 44).

3. Control panel (10) according to any of the preceding claims in which some elements (54) of the means of protection (50) project from the main surface (32) of the sheet (24) so that their top surface is at a distance from the inner surface (26) of the fascia (12), thus forming guides which the liquid (20) follows by capillary action and converges towards an outlet (62).

4. Control panel (10) according to any of the preceding claims in which some elements (56) of the means of protection (50) are formed as hollows in the actual thickness of the sheet (24), forming gullies (56) sloping (p) in the vertical plane (PZ), the liquid (20) following these gullies (56) by capillary action and converging towards an outlet (62).

5. Control panel (10) according to any of the preceding claims in which an area (64) of the main surface (32) of the sheet (24) is completely smooth, of the polished mirror type, said mirror area (64) promoting the flow of liquid (20) and thus avoiding its stagnation and cooperating with the other elements of the means of protection (50) so as to discharge the liquid (20) towards an outlet (62).

6. Control panel (10) according to any of the preceding claims in which an area (66) of the main surface (32) of the sheet (24) is grained, slowing down the flow of liquid (20) and so preventing drops from arriving too quickly on elements of the means of protection (50) and not passing over in a cascade effect, the grained area (66) thus cooperating with the other elements of the means of protection (50) so as to discharge the liquid (20) towards an outlet (62).

7. Control panel (10) according to any of the preceding claims in which the elastomer sheet (24) comprises a first partial sheet (24a) provided with a first portion of the means of protection (50a) and a second partial sheet (24b) provided with a second portion of the means of protection (50b), the partial sheets (24a, 24b) being juxtaposed, the first and second portions of the means of protection (50a, 50b) cooperating with each other to discharge towards an outlet (62) the liquid (20) which penetrates into the panel (10).

8. Control panel (10) according to claim 7 in which the juxtaposed partial sheets (24a, 24b) join along a boundary forming a gully in a slight hollow compared with the main surfaces of the partial sheets (24a, 24b), said gully sloping (p) in the vertical plane (PZ) and cooperating with the elements of the means of protection (50) so as to discharge the liquid (20) towards an outlet (62).

9. Control panel (10) according to any of the preceding claims in which the means of protection (50) further comprises linear elements projecting from the inner surface (26) of the fascia (12), wherein said elements of the inner surface (26) cooperate with elements of the sheet (24) so as to discharge the liquid (20) towards an outlet (62).

10. Control panel (10) according to any of the preceding claims in which the sheet (24) is further provided with deformable domes (30) projecting from the main surface (32) of the sheet (24), the domes (30) being arranged so that the actuation of a control button (14) causes elastic deformation of a dome (30), generating a return force opposite to the actuation of the control button (14), the button regaining its initial position after being released.
